# EUROPEAN PATENT SPECIFICATION

(11) **EP 3 841 511 B1**
(45) Date of publication and mention of the grant of the patent: **26.07.2023**
(21) Application number: 18765563.4
(22) Date of filing: 20.08.2018
(51) Int. Cl.: G06F 30/00

(54) **VISUAL MODELLING SYSTEM AND METHOD THEREOF**
VISUAL MODELLING SYSTEM UND VERFAHREN
SYSTÈME DE MODÉLISATION VISUELLE ET SON PROCÉDÉ

(43) Date of publication of application: 30.06.2021
(73) Proprietor: The Giant Company Attractions Limited, Dublin D02 RW82 (IE)
(72) Inventor: DUNNING, Paddy, Dublin, D02 RW82 (IE)
(74) Representative: MacLachlan & Donaldson
(86) International application number: PCT/EP2018/072458
(87) International publication number: WO 2020/038553

(56) References cited:
- EP-A1- 1 870 802
- US-A1- 2017 004 228

## Description

### Field

The present invention generally relates to a tourist attraction installation. More in particular, the present invention relates visual modelling apparatuses, methods and systems which may be used to create and generate large-scale visual models on sculptures and other objects.

### Background

Major entertainment and tourist attractions from landmark structures to entertainment complexes, such as Disney World, Times Square and Grand Central Station in the U.S. and others throughout the world, receive tens of millions of visitors every year. To keep visitors engaged, there is always a need for new and novel ways to attract visitors' attention and create those awe-inspiring reactions that keep visitors returning and encouraging others to visit. There is a broad range of attractions from those that create thrills, like roller coasters and other amusement park rides that soar ever higher and faster, to those that are visually awe-inspiring like the Eiffel Tower or Mount Rushmore. While the known visually awe-inspiring attractions are undoubtedly impressive, there is a need for more engaging and interactive visual attractions that will keep new generations of visitors captivated.

An example of a tourist attraction installation is described in US20170004228. The tourist attraction installation described therein, allows visitors to project an image of themselves into a large-scale model visually. However, one of the issues with the described installation is that inaccuracies between the scanned object dataset and the exact position of the lighting elements on the surface of the large-scale model may affect the quality of the image being projected.

### Summary of the invention

The present invention aims to provide apparatuses, methods and systems for providing an interactive tourist attraction installation that overcomes the disadvantages of the prior art solutions.

This aim is achieved according to the invention by the visual modelling system showing the technical characteristics of the first claim.

According to an aspect of the present invention, a visual modelling system is provided. The visual system comprises a first scan data set associated with a subject; a structure having a plurality of addressable lighting elements disposed of approximate to the surface of the structure; a second scan data set associated with the location of the addressable lighting elements on the surface of the structure; a processor-based image processing system including a data receiving module to receive the generated first scan data set, and a mapping engine to relate the first scan data set to positionally corresponding lighting elements on the structure as defined by the second dataset; and an electronic lighting control system including a power source and a lighting controller in communication with the plurality of addressable lighting elements, wherein the electronic control system energizes the addressable lighting elements in accordance with the mapping engine's relationship between the first and second scan data sets, wherein, the visual modelling system comprises a structure scanning module operable for generating the second scan data set by building a 3D virtual model of the structure, which 3D virtual model defines the location of the lighting elements and the order the electronic lighting control system addresses them, wherein the structure scanning module is configured for building the 3D virtual model of the structure by performing the steps of:
a) operating the electronic lighting control system to cycle through the addressable lighting elements one at a time;
b) operating scanning equipment configured to scan the structure from different angles, the scanning equipment being configured for detecting the light generated by each energised addressable lighting element;
c) building a point cloud from the detected light emitted from each addressable lighting element, each point defining the location of the addressable lighting elements on the surface of the structure and the order in which the electronic lighting control system addresses them; and
d) converting the point cloud into the 3D virtual model of the structure.

It has been found, that by building a 3D virtual model of the structure has the advantage of increasing the accuracy of the image projected onto the structure surface. A 3D virtual model comprises more data points than a traditional 2D scan. As a result, the mapping engine can more accurately map the first scan data set to the second scan data set, thereby creating a more realistic and detailed visual representation of the scanned object on the surface of the structure. The increase in mapping accuracy may significantly increase the number of visitors visiting the tourist attraction installation each year, which may boost the economy of the local community.

It has been found that executing the above steps has the advantage of reducing the processing power and storage required for building the 3D virtual model. The generation of a point cloud made up of a set of points located in a three-dimensional coordinate system, requires significantly less storage and processing power than a comparable 3D model made up of surfaces. The collection of data points can be converted into a polygonal model that may be rendered like a traditional 3D model. The processing of the data obtained by the scanning equipment, and the building of the point cloud, may be performed by a processing unit, which may be part of the processor-based image processing system. Furthermore, the generation of the point cloud may significantly improve the mapping reliability and accuracy, while reducing mapping distortions caused by not being able to map all data points from one set to the other.

According to embodiments of the present invention, steps a) and b) are performed synchronously such that when each addressable lighting element is energised, the scanning equipment is operated at the same time. As a result, a more accurate mapping of the position of the addressable lighting elements may be achieved. According to embodiments of the present invention, the steps a) and d) for generating the 3D model may be performed by means of an executable computer program loaded into a memory of a processor.

According to embodiments of the present invention, the scanning equipment may be in the form of a movable scanner. The scanner being configured for scanning the structure from different angles. The scanner may comprise a LIDAR scanner arranged for identifying the spatial position of the addressable lighting element, and a RASTER scanner arranged for identifying the addressable lighting element as a bright point. According to embodiments of the present invention, a plurality of scanners may be deployed at a different location around the structure. According to embodiments of the present invention, the scanner may be positioned at ground level. According to embodiments of the present invention, the scanner may be part of an aerial drone device, also referred to as Unmanned Aerial Vehicles, which may be remotely operated by a user.

According to embodiments of the present invention, the electronic lighting control system is configured for comparing the generated 3D virtual model to an expected addressable lighting element map of the structure to identify the presence of faulty addressable lighting elements on the structure surface causing a luminescence uniformity discrepancy. The luminance and/or colour non-uniformity may be caused by a faulty addressable lighting element, e.g. non-operational, brightness colour issues. Furthermore, the luminance and/or colour non-uniformity may be caused by an addressable lighting element being positioned at the wrong location on the structure surface. The position of the addressable lighting elements may be affected by several factors, e.g. weather, misalignment during structure assembly, general wear and tear, and the like. According to embodiments of the present invention, the electronic control system is configured, for generating a list containing the location of the faulty addressable lighting elements detected, which list is communicated via a communication network to a system administrator. In this way, faulty addressable lighting elements can be quickly fixed, thus ensuring that quality of the projected scanned image is not affected. The list generated may further contain other information, such as the potential cause of the fault, e.g. position or operation of the addressable lighting element, and/or the image resolution lost due to the faulty addressable lighting elements detected. In this way, the system administrator can better assess the severity of the luminance and/or colour non-uniformity and accordingly order a corrective action.

According to embodiments of the present invention, the electronic control system is configured, when luminance and/or colour non-uniformity is detected, for adjusting the current supplied to addressable lighting elements. In this way, the colour intensity and/or brightness of the addressable light elements neighbouring the affected structure area can be adjusted to at least partially correct the luminance and/or colour non-uniformity caused by the detected faulty addressable lighting element(s).

According to embodiments of the present invention, the electronic control system is configured for adjusting the pulse width supplied to each addressable lighting element. The pulse width is applied to each addressable light element by the electronic lighting controller. Pulse Width Modulation (PWM) is a widely used technique to control the brightness of the addressable lighting elements and can be used to perform uniformity correction. PWM works by operating the addressable lighting elements either full on or full off at a very high rate. The flashes are so fast that the human eye cannot notice them and the duration of the individual flashes (pulse width) determines the perceived brightness.

According to embodiments of the present invention, the structure is formed in the approximate shape of the type of subject scanned. For example, the subject scanned may be in the shape of a human figure. The scan data set may be a three-dimensional set of data, and the structure is formed in the approximate three-dimensional shape of the type of subject scanned. A three-dimensional scanner may be used for scanning a subject to be visually modelled. Using a three-dimensional set of data has the advantage of improving the reliability and accuracy of mapping the scanned image to the structure so that an accurate representation of the scanned subjects is achieved.

According to embodiments of the present invention, the mapping engine is configured for mapping the 3D point locations defined in the second scan data set to a 2D image points defined in the first data set. In this way, a simple camera may be used instead of a 3D scanner for scanning the subject, thus significantly reducing the cost of the subject scanning equipment. The mapping of the 2D image of the first scan dataset to the 3D virtual model defined in the second scan data set may be is performed by means of a UV mapping technique. A UV mapping technique involves the 3D modelling process of projecting a 2D image to a 3D model's surface for texture mapping. The letters "U" and "V" denote the axes of the 2D texture because "X", "Y" and "Z" are already used to denote the axes of the 3D object in model space.

According to embodiments of the present invention, the human shaped structure includes at least one of a moveably attached head, neck, arm, torso or leg and a powered actuator for moving at least one of the head, neck, arm, torso or leg. The system may include at least one movement sensor and movement processing engine to translate a subject's movements into movement commands sent to the at least one actuator whereby a user can control the movement of the structure. In this way, the human shaped structure may imitate basic movements made by the scanned subject e.g. moving head, arms, bending, and the like. According to embodiments of the present invention, the overall shape of the human-shaped structure may change depending on the shape of the scanned subject. For example, portions of the structure may be moved inwards or outwards to increase or decrease the diameter of predetermined sections of the structure e.g. arms, stomach, and the like. In this way, a more realistic representation of the scanned subject may be achieved.

According to embodiments of the present invention, the structure is at least ten times larger than the scanned subject.

According to embodiments of the present invention, the scan data set may be in the form of a video and wherein the electronic lighting control system energizes the addressable lighting elements to generate a moving image on the structure.

According to embodiments of the present invention, the lighting elements are outwardly facing light emitting diodes (LEDs) arranged in a plurality of vertically spaced horizontal rows.

According to embodiments of the present invention, the head and front portion of the torso have a higher density of light emitting diodes than the rest of the body. For example, the face portion of the head has a higher density of light emitting diodes than the front portion of the head and torso.

According to embodiments of the present invention, the structure comprises a plurality of interconnecting blocks, each block comprising at least one addressable lighting element. As a result, the structure can be easily and quickly assembled and dis-assembled. Each block may comprise at least one socket configured for receiving at least one addressable lighting element. The socket may be an electric socket arranged for providing power signals to the addressable lighting element secured therein. For example, the addressable lighting elements may be positioned on the structure after the structure has been assembled.

According to embodiments of the present invention, the addressable lighting elements may be draped and secured after assembly of the structure. In this way, there may be no need to provide sockets on the structure surface.

According to embodiments of the present invention, the blocks forming the structure may be in the form of pixel tiles or pixel blocks. The pixel tiles may be provided with a plurality of addressable lighting elements.

According to embodiments of the present invention, each block comprises interconnecting elements configured for releasably connecting each block to each neighbouring block. The interconnecting elements may be configured for carrying power signals between the blocks for controlling the operation of the addressable lighting elements.

It is also provided a method as defined in appended claim 15 of running a visual modelling system as claimed in claim 1.

### Brief Description of the drawings

The following drawings are provided as an example to explain further and describe various aspects of the invention.
Figures 1 and 2 show and exemplify a tourist attraction installation according to embodiments of the present invention
Figure 3 shows an example of a method for visually modelling a scanned image of an object on the structure according to embodiments of the present invention.
Figures 4 shows an exemplified representation of the visual modelling system according to embodiments of the present invention
Figure 5 shows an exemplified data flow diagram for obtaining the 3D virtual model of the structure according to embodiments of the present invention

### Detailed Description

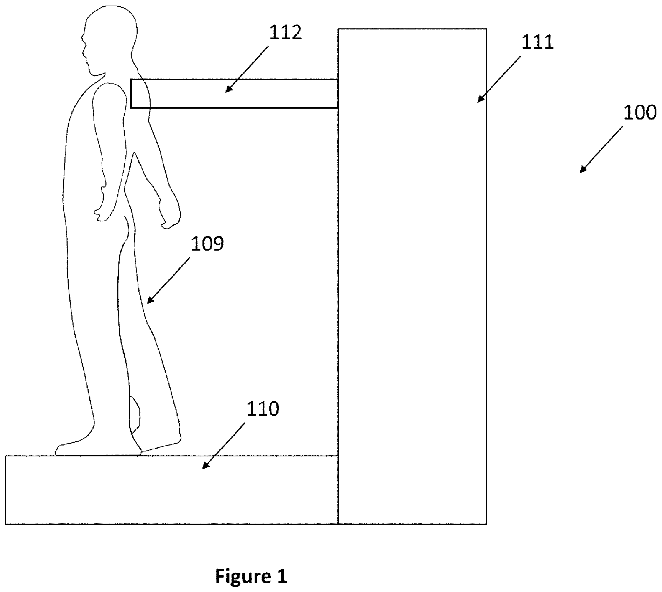

The present invention will be illustrated using the exemplified embodiments shown in the figures 1 to 5, which will be described in more details below. It should be noted that any references made to dimensions are only indicative and do not restrict the invention in any way. While this invention has been shown and described with reference to certain illustrated embodiments thereof, it will be understood by those skilled in the art that various changes in form and details may be made therein without departing from the scope of the invention encompassed by the appended claims. Furthermore, while the invention has been described with references to a particular interactive tourist attraction installation, it should be understood by those skilled in the art that changes in form and details may be made to facilitate other types of tourist attraction installations without departing from the scope of the invention encompassed by the appended claims.

All publications, patents, patent applications and other references mentioned herein are hereby incorporated by reference in their entireties for all purposes as if each individual publication, patent or patent application were specifically and individually indicated to be incorporated by reference and the content thereof recited in full.

The visual modelling system described herein provides a system and method for creating an awe-inspiring amusement and entertainment structure. The vast majority of large-structures today are static and unless having some historic significance are generally of fleeting interest as attractions. The system and method disclosed herein creates a unique and appealing attraction by creating an interactive large-scale structure that can be used to model a smaller figure on a large-scale figure with increased accuracy in comparison to the known methods, such as the one disclosed in US20170004228.

In various embodiments, the system can be used to scan and generate a three dimensional ("3D") representational image of a person such as a visitor to the attraction and then the representation can be modelled on the large-scale structure. Various other embodiments may also include movement by means of both streaming video of the visitor and moveable appendages provided on the structure that can be controlled by a visitor to the attraction.

In simple terms, in one preferred embodiment, each person or visitor entering the visitor attraction will enter a 2D or 3D scanner and their image, video and audio will be scanned and digitized using known scanning and recording techniques. The data will then be processed and transposed to a corresponding matrix map of lighting elements embedded in the structure so that the visitor's likeness may be replicated on the large-scale structure. The audio-video image may also be scanned remotely or acquired from stored data, such as, to replicate celebrities or other famous figures, and be transmitted and or saved to be uploaded at a later time on a large-scale "Giant" structure.

Referring to figure 1, there is shown an illustration of a tourist attraction installation 100 provided with a large-scale structure 109 built in the form of a standing human figure having a head, arms, torso and legs built upon a pedestal 110. While the embodiments depicted herein are a human form, any 3D object could be modelled with the appropriate form, for example, structures might be built to represent or model dinosaurs or other animals. A tower 111 and a platform 112 may be provided to allow the visitors to climb to the top of the structure.

The large-scale structure 109 may be built by any know construction means such as steel or wood frame construction and may be skinned or unskinned. In one embodiment the structure is constructed from a wood frame with horizontal rendering slats or framing defining the form of the object to be modelled. In some embodiments, the front edges of the segments of wood or another material which the structure or Giant is constructed, may be covered with a transparent skin, such as, a diffusion Plexiglass. Addressable lighting elements may be mounted and recessed behind the glass or other see through membrane. In some embodiments the lighting elements are preferably clusters of red, green and blue light emitting diodes, however, any known light emitter may be used.

The large-scale structure 109 may be built from interconnecting pixel blocks, each block comprising at least one addressable lighting element, as previously described. Each block may be configured for being connected to a neighbouring block via interconnecting means. For example, each block may be provided on at least one side with an opening, and on another side with a protruding element. In this way, the pixel blocks can be interconnected by pushing the protruding opening provided into the opening of a neighbouring block. The blocks may be provided on at least one side with an opening and a protruding element. The interconnecting means may be arranged to carry electrical signals e.g. power signal, data signal, control signals, etc. Each block may comprise a plurality of pixels comprising at least one addressable lighting element addressed in a similar way to known LED displays. It should be noted that the blocks may be secured in any way known to the skilled person e.g. bolts, clamps, etc.

The lighting elements may be placed at varying depths of recess and the pitch of the pixels may be varied to alter the visual appearance of each pixel. By controlling the pitch and depth of the lighting elements the visual appearance may be configured to create sharp edges or vast pixels that blend into each other.

The array or matrix of lighting elements on the structure will preferably cover the entire structure, including the front, back and sides. The pixel resolution or distribution, density or size of lighting elements on the structure may be uniform and consistent, or in some embodiments may be distributed to provide finer resolution in critical areas of the structure. For example, in a human form structure of one embodiment, the majority of the horizontal segments in the structure, which in aggregate create the body of the sculpture, may be mounted with large pixels having a horizontal pitch between 1.0 to 25 cm. For example, the head-excluding the face-and the front torso may be constructed of 4000 medium-pitch pixels with a horizontal pitch of approximately 10 cm. In some embodiments, the vertical pitch is preferably determined by the distance between the individual segments of horizontal structure. For example, the segments creating the face are in aggregate embedded with 3,000 small pixels with approximately 5 cm pixel pitch sufficient for viewing distances of more than 50 m as well as coherent images being visible while standing directly in front of the structure. These exemplary pixel/lighting element distributions in one embodiment may be used on a structure of having a predetermined high e.g. at least 10 larger than the size of the scanned object-it will be understood that higher or lower numbers of lighting elements may be used on proportionally sized structures or as enhanced or decreased resolution is desired.

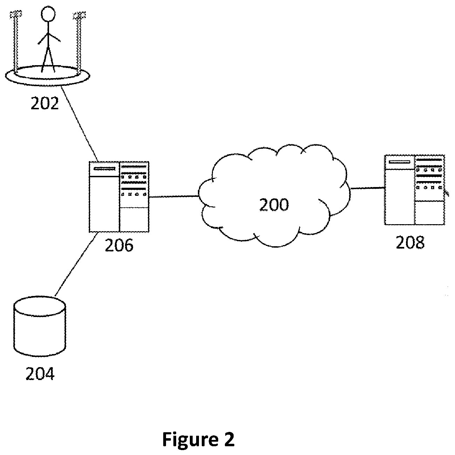

Referring to figure 2, a block diagram of the visual modelling system 200 is illustrated. The system in one embodiment includes a 2D or 3D scanner 202 that is used to scan visitors to the attraction 100. The system also may include a storage unit 204 and database to buffer or store scanned data. In addition to image data received from the 3D scanner 202, the system and method may receive or use previously scanned or generated data, either stored on storage unit 204 or streamed in real time to be displayed on the large-scale model. While the images in one embodiment preferably relate to the form of the sculpture, the images may be any photographic imagery or any of a myriad of static or moving visual images-either representational or abstract.

The visual modelling system 200 may include one or more servers 206, 208. In other embodiments the entire systems may be self-contained and operate from a single server. The servers 206, 208 may be of any known type of readily available system including a processor, memory and communication ports as such for receiving and transmitting data from and to external devices via any known data receiving and transmitting hardware and software modules.

The server or servers 206, 208 may be connected to and/or communicate with entities such as, but not limited to: one or more users from user input devices such as keyboard and mice to control the system; peripheral devices such as scanner 202 or other devices such as a positional input device (e.g., to allow a use to control movement of the large scale structure); and output controllers to activate and command control circuitry (e.g., to power and control the lighting element matrix and the motion actuators in the large scale structure).

As shown in FIG. 2, the visual modelling system is distributed and includes two or more computers or servers 206, 208 connected by a communications network 200. In such embodiments the scanning and storage system may be adjacent to or remote to the large-scale structure. For example, in this configuration the large-scale structure could be used to permit remote performances, speeches, or presentations wherein a singer, actor, or speaker can make an appearance before a large audience at varied locations in real time by transmitting a live feed to multiple large scale "Giant" structures located around the country or world via the communications network 200.

The network 200 facilitates the transfer of information from source points to destinations. There are many forms of networks that may be suitable for use, such as, Local Area Networks (LANs), Pico networks, Wide Area Networks (WANs), Wireless Networks (WLANs), etc. For example, the Internet is generally accepted as being an interconnection of a multitude of networks whereby remote clients and servers may access and interoperate with one another and may be used to facilitate such remote video and imagery transmission to the large-scale structure.

The visual modelling system 200 also includes software modules including a communications module, mapping engine, a controller module, a movement processing engine, and a structure scanning module. The communications module is any known interface module using standard communications protocols to communicate over Local Area Networks (LANs), Pico networks, Wide Area Networks (WANs), Wireless Networks (WLANs), and with peripheral devices such as scanner 202, storage unit 204 and an electronic control system for controlling the lighting matrix. The mapping engine and controller module software may be separate modules or be combined into a single module.

The function of the mapping engine is to transform the image data to the 3D lighting element matrix on the large scale "Giant" structure. This process is preferably carried out by relational mapping of the scanned or stored image data to the lighting matrix. The process may include the use of known downscaling or downsampling algorithms (e.g., nearest neighbour, linear, cubic, or bicubic) to reduce the resolution of the original which will typically be higher than the resolution of the light element matrix on the large-scale structure. Where a high pixel density is used on the large-scale structure upscaling or upsampling may be necessary and can be carried by any similar known techniques. In some embodiments, since the pixel resolution or density varies across the large-scale structure selective upscaling or downscaling may be used on portions of the image to map the image to the lighting matrix of the large-scale Giant structure. For example, in a human form embodiment, where the face has a high pixel density in certain embodiments upscaling may be necessary, whereas, the legs and arms of the large-scale structure may have low pixel density and may need to be downscaled to map to the lighting element matrix.

The controller module interfaces with a lighting control system that addressable energises the lighting elements. The lighting elements may be addressed by any known method used in conjunction with traditional LED displays, such as, arranging the light elements in a passive matrix and using multiplexing techniques to reduce the number of physical connections. Alternatively, the lighting element matrix may be configured using active matrix techniques to provide faster response times in video and multimedia version of the system and method.

The lighting control system circuitry may also include power source and/or lighting control for the lighting element matrix and may be wired in a combination of series and parallel configurations using an AC mains voltage supply transformed to a lower voltage and rectified to a stabilized DC output. Pulse width modulation may be used for dimming the lighting elements. Data communications may use a TCP/IP based protocol, such as Artnet or sACN, or other protocols described above for fast display of lighting changes.

The control module provides the software communications interface with the lighting control system, and in some embodiments provides the commands to drive the lighting sequence of the lighting element matrix. In alternative embodiments the control module functions and lighting control system may be combined in a single unit for example in server 208 in base 110.

The movement processing engine provides software for receiving movement data and relating the movements into commands to control actuators on the Giant. Movement data may be received from movement sensors attached to a user, scans of the user's movements, or from a movement file stored in memory. The movement processing engine is connected directly or wirelessly the via servers or controllers to actuators controlling the Giant's appendages and sends movement commands to the actuators to create movement.

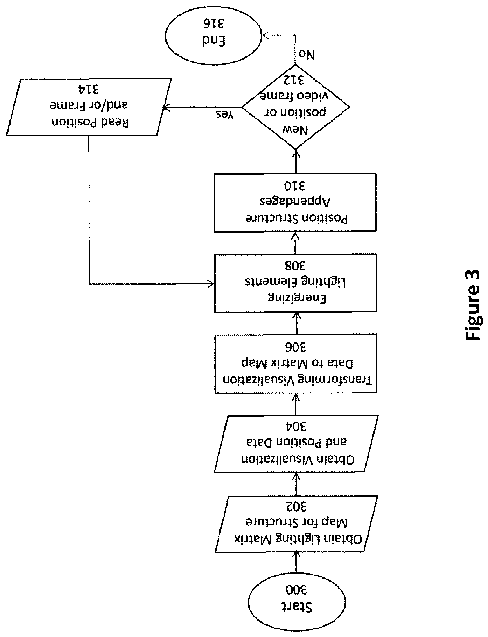

Referring to figure 3, a flow diagram of one embodiment is illustrated. The exemplary flow diagram illustrates how the system may function as a tourist attraction. The process starts at 300 with a visitor or user entering the attraction. At start-up, the system would load a lighting matrix map containing a map of the addressable lighting element layout for the large-scale Giant structure in Step 302. Next, the system will load or scan data associated with the visitor (e.g. first scan data set) in Step 304. In one embodiment, the visitor preferably steps into a 3D scanner upon entry to the attraction. The 3D scanner, in turn, scans the visitor and generates visualisation and/or position data for the visitor. The visualization data is essentially a scan of both the visitor's 3D form and image data. The position data may optionally be used to pose the large-scale structure's appendages to match those of the visitor, or with a real-time scanner to read the visitors movement and move the structure in sync with the visitor's movements.

In Step, 306 the mapping engine transforms and maps the visualisation data such as the visitor's image data onto the matrix map for the lighting elements using upscaling, downscaling and/or relational mapping as discussed above. In step 308, the lighting control system and module, energize the lighting elements in accordance with the transformed visualization data.

In embodiments having movable appendages, in Step 310 the appendages are positioned using the control module and system to move actuators in the arms, legs, neck and torso to pose the structure in accordance with the visitor's movements. In systems configured for interactive or real-time video or movement, in Step 312, the system will look for updated frame or movement data. Information on movement may be read from a 3D scanner, other sensors or actuators attached to or controlled by the visitor of from a pre-recorded movement file stored in memory. Similarly, image or video data may be retrieved from real-time scans or pre-recorded video in the storage system. If there are additional movements or video for the next frame of movement and display, the data is retrieved in Step 314. Thereafter the process repeats, displaying and positioning the figure according to the next frame in Steps 308 through 310. This process may repeat until the entire video is played or some allotted period for the visitor expires and the process ends at Step 316.

The steps 310-316, may also be accompanied by audio or sound in sync with the image display and movement of the Giant. In some embodiments, the audio is from the user or visitor engaged with the Giant. In other embodiments, the audio may be part of a recorded video segment such as from a speech.

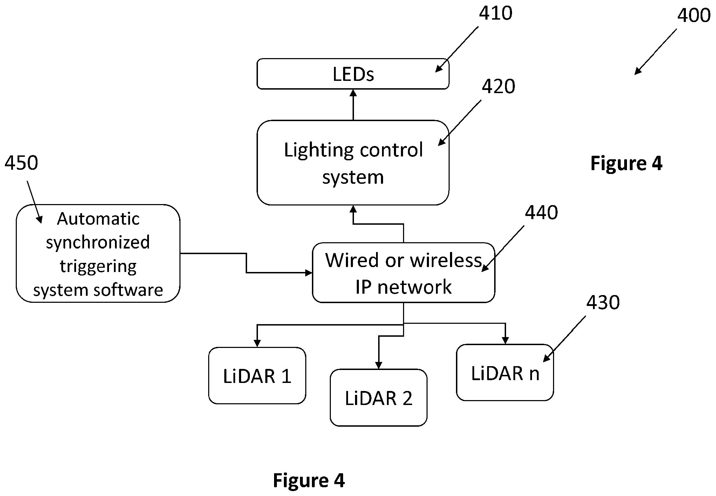

Figure 4, shows an exemplified embodiment of a structure scanning module 400 for generating the lighting matrix map of the structure according to embodiments of the present invention. The structure scanning module 400 is operable for generating a 3D virtual model of the structure 109 by mapping the position of the LEDs 410 positioned on the structure surface and the order each lighting element is addressed by the electronic lighting control system 420. The structure scanning module 400 is configured for generating the 3D virtual model of the structure by performing a series of steps, which includes:
a) operating the electronic lighting control system 420 to cycle through the LEDs 410 one at a time;
b) operating scanning equipment 430 configured to scan the structure 109 from different angles, the scanning equipment being configured for detecting the light emitted by each energised LED 410;
c) building a point cloud from the detected light emitted from each LED 410, each point defining the location of the LEDs 410 on the surface of the structure 109 and the order they are addressed by the electronic lighting control system 420; and
d) converting the point cloud into a 3D virtual model of the structure 109.

The structure scanning module 400 may comprise a triggering software module 450 configured for synchronously triggering the operation of the electronic lighting control system 420 and the scanning equipment 430.

The scanning equipment used for scanning the structure may comprise known scanning equipment 430 such as LIDAR and RASTER scan systems, which may be operated via a wireless or wired communication data network 440. For example, the LIDAR scanner may be arranged for capturing the spatial position of the LED 410 while the RASTER scanner may be arranged for identifying the LED 410 as a bright point. It should be noted that any other known scanning equipment may be used for generating point could representing the position of the addressable lighting elements on the structure.

The content for the lighting element matrix, movement and audio may be generated in a real-time or nearly real-time interactive program that uses video streams from cameras and face-detection algorithms to capture images and videos, movements and sounds such as of human figures or faces. These images are then processed to derive abstract images or motion pictures that are mapped onto the lighting element matrix. The mapping may be implemented using known coding environments and techniques, including, visual live programming environments such as the freely available MaxMSP/Max 7.1 (https://cycling74.com/products/max/) or vvvv (https://vvvv.org). Similarly, as discussed above, the scanned or computer-generated images, video and/or audio may be loaded onto a flash memory data storage card which is inserted into a media player to be mapped to the lighting element matrix.

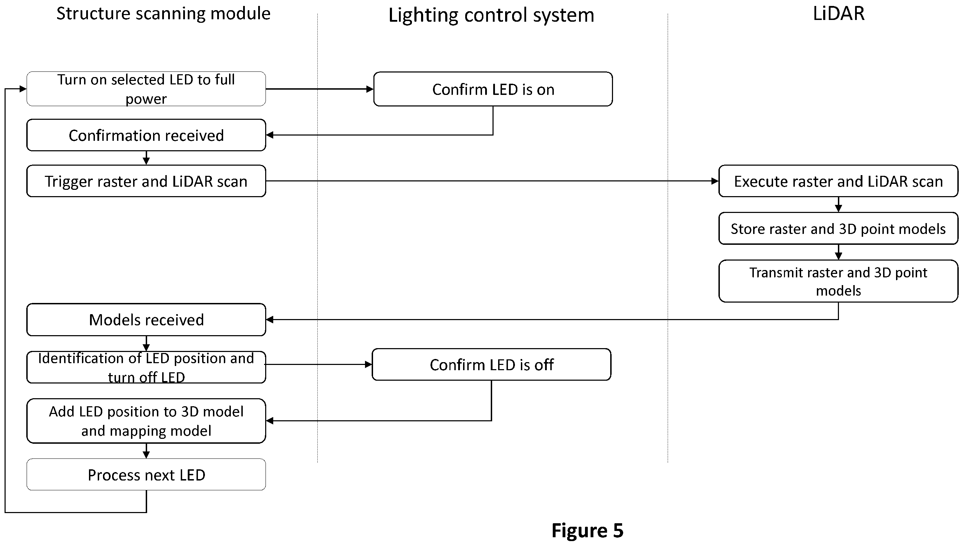

Referring to figure 5, an exemplified data flow for building the 3D virtual data model is presented. The structure scanning module 400 operates the electronic lighting control system 420 to energise one of the LEDs 410 on the structure surface. The electronic lighting control system 420 energises an LED 410 according to an addressable LED map, which may be stored in the lighting control system 420, and confirms to the structure scanning module 400 that the LED is on. Once the confirmation is received from the electronic lighting control system 420, the structure scanning module 400 triggers the scanning equipment 430 to perform a LIDAR and RASTER scan. The scanning equipment 430 once receiving the triggering command execute a LIDAR and RASTER scan, store the raster and 3D point models obtained, and transmit the stored models to the structure scanning module 400. Once the models are received at the structure scanning module 400, the transmitted scanned data is processed to identify the LED position on the structure 109 and a signal is transmitted to the electronic lighting control system 420 to turn-off the energised LED 410. Once confirmation has been received from the electronic lighting control system 420 that the LED 410 has been turned-off, the structure scanning module 400 adds the detected LED position to a 3D model and mapping model of the structure. The process is repeated until all LEDs 410 on the structure, or at least a desirable amount of LEDs 410, have been energised by the electronic lighting control system 420 .

The method for building the 3D virtual data model may be executed at regular intervals, e.g. one a day or more often if necessary. In this way, faulty addressable light elements can be quickly identified and fixed.

In general, the routines executed to implement the embodiments of the invention, whether implemented as part of an operating system or a specific application, component, program, object, module or sequence of instructions, or even a subset thereof, may be referred to herein as "computer program code," or simply "program code." Program code typically comprises computer readable instructions that are resident at various times in various memory and storage devices in a computer and that, when read and executed by one or more processors in a computer, cause that computer to perform the operations necessary to execute operations and/or elements embodying the various aspects of the embodiments of the invention. The computer readable program instructions for carrying out operations of the embodiments of the invention may be, for example, assembly language or either source code or object code is written in any combination of one or more programming languages.

The program code embodied in any of the applications/modules described herein is capable of being individually or collectively distributed as a program product in a variety of different forms. In particular, the program code may be distributed using a computer readable storage medium having computer readable program instructions thereon for causing a processor to carry out aspects of the embodiments of the invention.

Computer readable storage media, which is inherently non-transitory, may include volatile and non-volatile, and removable and non-removable tangible media implemented in any method or technology for storage of information, such as computer-readable instructions, data structures, program modules, or other data. Computer readable storage media may further include RAM, ROM, erasable programmable read-only memory (EPROM), electrically erasable programmable read-only memory (EEPROM), flash memory or other solid state memory technology, portable compact disc read-only memory (CD-ROM), or other optical storage, magnetic cassettes, magnetic tape, magnetic disk storage or other magnetic storage devices, or any other medium that can be used to store the desired information and which can be read by a computer. A computer readable storage medium should not be construed as transitory signals per se (e.g., radio waves or other propagating electromagnetic waves, electromagnetic waves propagating through a transmission media such as a waveguide, or electrical signals transmitted through a wire). Computer readable program instructions may be downloaded to a computer, another type of programmable data processing apparatus, or another device from a computer readable storage medium or to an external computer or external storage device via a network.

Computer readable program instructions stored in a computer readable medium may be used to direct a computer, other types of programmable data processing apparatus, or other devices to function in a particular manner, such that the instructions stored in the computer readable medium produce an article of manufacture including instructions that implement the functions/acts specified in the flowcharts, sequence diagrams, and/or block diagrams. The computer program instructions may be provided to one or more processors of a general-purpose computer, special purpose computer, or other programmable data processing apparatus to produce a machine, such that the instructions, which execute via the one or more processors, cause a series of computations to be performed to implement the functions and/or acts specified in the flowcharts, sequence diagrams, and/or block diagrams.

In certain alternative embodiments, the functions and/or acts specified in the flowcharts, sequence diagrams, and/or block diagrams may be re-ordered, processed serially, and/or processed concurrently without departing from the scope of the invention. Moreover, any of the flowcharts, sequence diagrams, and/or block diagrams may include more or fewer blocks than those illustrated consistent with embodiments of the invention. The terminology used herein is for the purpose of describing particular embodiments only and is not intended to be limiting of the embodiments of the invention. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof. Furthermore, to the extent that the terms "includes", "having", "has", "with", "comprised of", or variants thereof are used in either the detailed description or the claims, such terms are intended to be inclusive in a manner similar to the term "comprising".

While all of the inventions has been illustrated by a description of various embodiments and while these embodiments have been described in considerable detail, it is not the intention of the Applicant to restrict or in any way limit the scope of the appended claims to such detail. Additional advantages and modifications will readily appear to those skilled in the art. The invention in its broader aspects is therefore not limited to the specific details, representative apparatus and method, and illustrative examples shown and described. Accordingly, departures may be made from such details without departing from the scope of the Applicant's general inventive concept.

The scope of the invention is defined by the appended claims.

## Claims

1. A visual modelling system, comprising:
a first scan data set associated with a subject;
a structure (109) having a plurality of addressable lighting elements (410);
a second scan data set associated with the location of the addressable lighting elements (410) on the surface of the structure (109);
a processor-based image processing system (206) including a data receiving module to receive the generated first scan data set, and a mapping engine to relate the first scan data set to positionally corresponding lighting elements (410) on the structure (109) as defined by the second scan data set; and
an electronic lighting control system (420) including a power source and a lighting controller in communication with the plurality of addressable lighting elements (410), wherein the electronic lighting control system (420) energizes the addressable lighting elements (410) in accordance with the mapping engine relation between the first and second scan data sets;
**characterised in that** the visual modelling system comprises a structure scanning module (400) operable for generating the second scan data set by building a 3D virtual model of the structure (109) defining the location of the addressable lighting elements (410) and an order in which they are addressed, the structure scanning module (400) being configured for building the 3D virtual model of the structure by performing the steps of:
a) operating the electronic lighting control system (420) to cycle through the addressable lighting elements (410) one at a time;
b) operating scanning equipment (430) of the visual modelling system configured to scan the structure (109) from different angles, the scanning equipment (430) being configured for detecting the light emitted by each energised addressable lighting element (410);
c) building a point cloud from the detected light emitted from each addressable lighting element (410), each point defining the location of the addressable lighting elements (410) on the surface of the structure (109) and the order they are addressed by the electronic lighting control system (420); and
d) converting the point cloud into a 3D virtual model of the structure (109).

2. The visual modelling system of claim 1, wherein steps a) and b) are performed synchronously such that when each addressable lighting element (410) is energised, the scanning equipment (430) is operated at the same time, and optionally wherein the steps a) and d) are performed by means of an executable computer program loaded into a memory of a processor.

3. The visual modelling system of any preceding claim, wherein the scanning equipment (430) comprises at least one rotatable scanner and optionally wherein the scanning equipment (430) comprises at least one LIDAR scanner arranged for identifying a spatial position of the addressable lighting element (410), and at least one RASTER scanner arranged for identifying the addressable lighting element (410) as a bright point.

4. The visual modelling system of claim 3, wherein the electronic lighting control system (420) is configured for comparing the generated 3D virtual model to an expected addressable lighting element map of the structure to identify the presence of faulty addressable lighting elements (410) on the structure surface causing a luminescence uniformity discrepancy.

5. The visual modelling system of claim 4, wherein the electronic lighting control system (420) is configured, for generating a list containing the location of the faulty addressable lighting elements detected, which list is communicated via a communication network to a system administrator.

6. The visual modelling system of claim 4 or 5, wherein the electronic lighting control system (420) is configured, when a luminance and/or colour non-uniformity is detected, for adjusting the operation of addressable lighting elements neighbouring the affected structure area and optionally wherein the electronic lighting control system (420) is configured for adjusting any of the current supplied to each addressable lighting element, the pulse width supplied to each addressable lighting element.

7. The visual modelling system of any one of the preceding claims, wherein the structure (109) is formed in the approximate shape of the type of the subject scanned and optionally wherein the first scan data set is a three-dimensional set of data, and the structure (109) is formed in the approximate three-dimensional shape of the type of the subject scanned.

8. The visual modelling system of any one of the preceding claims, wherein the mapping engine is configured for mapping the 3D point locations defined in the second scan data set to 2D image points defined in the first data set and optionally wherein the mapping is performed by means of a UV mapping technique.

9. The visual modelling system of any one of the preceding claims, further comprising a three-dimensional scanner (202) for scanning a subject to be visually modelled.

10. The visual modelling system of any preceding claim , wherein the subject is a human and the structure (109) is formed in the shape of a human figure and optionally wherein the human-shaped structure includes at least one of a moveably attached head, neck, arm, torso or leg and a powered actuator for moving the at least one of the head, neck, arm, torso or leg and optionally wherein the system includes at least one movement sensor and movement processing engine to translate a subject's movements into movement commands sent to the at least one actuator whereby a user can control the movement of the structure (109).

11. The visual modelling system of any one of the preceding claims, wherein the structure (109) is at least ten times larger than the scanned subject and optionally wherein the first scan data set is video and wherein the electronic lighting control system energizes the addressable lighting elements to generate a moving image on the structure (109).

12. The visual modelling system of any one of the preceding claims, wherein the lighting elements are outwardly facing light emitting diodes arranged in a plurality of vertically spaced horizontal rows.

13. The visual modelling system of claim 12, when dependent on claim 10, wherein the head and front portion of the torso have a higher density of light emitting diodes than the rest of a body of the human-shaped structure and optionally wherein a face portion of the head has a higher density of light emitting diodes (410) than the front portion of the head and torso.

14. The visual modelling system of any one of the preceding claims, wherein the structure (109) comprises a plurality of interconnecting blocks, each block comprising at least one addressable lighting element (410) and optionally wherein the blocks are in the form of pixel tiles and optionally wherein each block comprises interconnecting elements configured for releasably connecting each block to each neighbouring block.

15. A method of running a visual modelling system as claimed in claim 1, **characterised in that** the method comprises the steps of generating a second scan data set by building a 3D virtual data model of a structure defining the location of the addressable lighting elements (410) and an order in which they are addressed, using the structure scanning module (400), the method comprising the steps of:
a) operating using the structure scanning module (400) an electronic lighting control system (420) to energise one of a plurality of addressable lighting elements (410) on the structure surface according to an addressable lighting elements map, which map is stored in a memory of the electronic lighting control system (420), wherein the electronic lighting control system (420) confirms to the structure scanning module (400) that the addressable lighting element (410) is energised;
b) once confirmation is received at the structure scanning module (400), operating at least one scanning equipment (430) to generate a 3D point model of the structure,
c) processing by the structure scanning module (400) the 3D point model to identify a position of the energised addressable lighting element (410) on the structure surface;
d) transmitting a signal to the electronic lighting control system (420) to turn-off the energised addressable lighting element (410);
e) once confirmation has been received from the electronic lighting control system (420) that the energised addressable lighting element (410) is turned-off, adding by means of the structure scanning module (400) the detected addressable lighting element position to a 3D model and mapping model of the structure; and
f) repeating steps a) to e) for the remaining addressable lighting elements (410) wherein step b) comprises the steps of:
b1) storing the scanning model; and
b2) transmitting the stored models to the structure scanning module (400) for further processing;
wherein the method further comprises the steps of:
g) receiving the generated first scan data set
h) mapping to relate the first scan data set to positionally corresponding lighting elements (410), and
i) energising the addressable lighting elements (410) in accordance with the mapping engine relation between the first and second scan data sets.

## Patentansprüche

1. Visuelles Modellierungssystem, umfassend:
einen ersten Scan-Datensatz, der mit einem Subjekt assoziiert ist;
eine Struktur (109), die eine Vielzahl von adressierbaren Beleuchtungselementen (410) aufweist;
einen zweiten Scan-Datensatz, der mit der Stelle der adressierbaren Beleuchtungselemente (410) auf der Oberfläche der Struktur (109) assoziiert ist;
ein prozessorgestütztes Bildverarbeitungssystem (206), das ein Datenempfangsmodul zum Empfangen des erzeugten ersten Scan-Datensatzes und eine Zuordnungsmaschine, um den ersten Scan-Datensatzes mit positionsmäßig entsprechenden Beleuchtungselementen (410) auf der Struktur (109) in Beziehung zu setzen, wie sie durch den zweiten Scan-Datensatz definiert sind, beinhaltet; und
ein elektronisches Beleuchtungssteuersystem (420), das eine Stromquelle und eine Beleuchtungssteuerung beinhaltet, die mit der Vielzahl von adressierbaren Beleuchtungselementen (410) in Verbindung ist, wobei das elektronische Beleuchtungssteuersystem (420) die adressierbaren Beleuchtungselemente (410) gemäß der Zuordnungsmaschine-Beziehung zwischen dem ersten und dem zweiten Scan-Datensatz mit Energie versorgt,
**dadurch gekennzeichnet, dass** das visuelle Modellierungssystem ein Struktur-Scanmodul (400) umfasst, das zum Erzeugen des zweiten Scan-Datensatzes durch Aufbauen eines virtuellen 3D-Modells der Struktur (109) betrieben werden kann, das die Stelle der adressierbaren Beleuchtungselemente (410) und eine Reihenfolge, in der sie adressiert werden, definiert, wobei das Struktur-Scanmodul (400) zum Aufbauen des virtuellen 3D-Modells der Struktur durch Durchführen der folgenden Schritte konfiguriert ist:
a) Betreiben des elektronischen Beleuchtungssteuersystems (420), um die adressierbaren Beleuchtungselemente (410) einzeln zu schalten;
b) Betreiben einer Scan-Ausrüstung (430) des visuellen Modellierungssystems, die konfiguriert ist, um die Struktur (109) aus verschiedenen Winkeln zu scannen, wobei die Scan-Ausrüstung (430) konfiguriert ist, um das von jedem energieversorgten adressierbaren Beleuchtungselement (410) emittierte Licht zu erfassen;
c) Aufbauen einer Punktwolke aus dem erfassten Licht, das von jedem adressierbaren Beleuchtungselement (410) emittiert wird, wobei jeder Punkt die Stelle der adressierbaren Beleuchtungselemente (410) auf der Oberfläche der Struktur (109) und die Reihenfolge, in der sie von dem elektronischen Beleuchtungssteuersystem (420) adressiert werden, definiert, und
d) Konvertieren der Punktwolke in ein virtuelles 3D-Modell der Struktur (109).

2. Visuelles Modellierungssystem nach Anspruch 1, wobei Schritt a) und b) synchron durchgeführt werden, sodass, wenn jedes adressierbare Beleuchtungselement (410) mit Energie versorgt wird, die Scan-Ausrüstung (430) gleichzeitig betrieben wird, und wobei Schritt a) und d) optional mittels eines ausführbaren Computerprogramms durchgeführt werden, das in einen Speicher eines Prozessors geladen ist.

3. Visuelles Modellierungssystem nach einem vorherigen Anspruch, wobei die Scan-Ausrüstung (430) mindestens einen drehbaren Scanner umfasst und optional wobei die Scan-Ausrüstung (430) optional mindestens einen LIDAR-Scanner umfasst, der zum Identifizieren einer räumlichen Position des adressierbaren Beleuchtungselements (410) angeordnet ist, und mindestens einen RASTER-Scanner, der zum Identifizieren des adressierbaren Beleuchtungselements (410) als einen hellen Punkt angeordnet ist.

4. Visuelles Modellierungssystem nach Anspruch 3, wobei das elektronische Beleuchtungssteuersystem (420) konfiguriert ist, um das erzeugte virtuelle 3D-Modell mit einer erwarteten Karte adressierbarer Beleuchtungselemente der Struktur zu vergleichen, um das Vorhandensein fehlerhafter adressierbarer Beleuchtungselemente (410) auf der Strukturoberfläche zu identifizieren, die eine Lumineszenz-Gleichförmigkeitsabweichung verursachen.

5. Visuelles Modellierungssystem nach Anspruch 4, wobei das elektronische Beleuchtungssteuersystem (420) konfiguriert ist, um eine Liste zu erzeugen, die die Stelle der erfassten fehlerhaften adressierbaren Beleuchtungselemente enthält, wobei die Liste über ein Kommunikationsnetzwerk an einen Systemadministrator übermittelt wird.

6. Visuelles Modellierungssystem nach Anspruch 4 oder 5, wobei das elektronische Beleuchtungssteuersystem (420) konfiguriert ist, um, wenn eine Lumineszenz- und/oder Farbungleichförmigkeit erfasst wird, den Betrieb von adressierbaren Beleuchtungselementen, die an den betroffenen Strukturbereich angrenzen, einzustellen, und optional wobei das elektronische Beleuchtungssteuersystem (420) konfiguriert ist, um einen beliebigen von dem Strom, der jedem adressierbaren Beleuchtungselement zugeführt wird, der Impulsbreite, die jedem adressierbaren Beleuchtungselement zugeführt wird, einzustellen.

7. Visuelles Modellierungssystem nach einem vorherigen Anspruch, wobei die Struktur (109) in der ungefähren Form des Typs des gescannten Objekts gebildet wird und optional wobei der erste Scan-Datensatz ein dreidimensionaler Datensatz ist und die Struktur (109) in der ungefähren dreidimensionalen Form des Typs des gescannten Objekts gebildet wird.

8. Visuelles Modellierungssystem nach einem vorherigen Anspruch, wobei die Zuordnungsmaschine konfiguriert ist, um die in dem zweiten Scan-Datensatz definierten 3D-Punktstellen 2D-Bildpunkten zuzuordnen, die in dem ersten Datensatz definiert sind, und optional wobei das Zuordnen mittels einer UV-Zuordnungstechnik durchgeführt wird.

9. Visuelles Modellierungssystem nach einem vorherigen Anspruch, ferner umfassend einen dreidimensionalen Scanner (202) zum Scannen eines Objekts, das visuell modelliert werden soll.

10. Visuelles Modellierungssystem nach einem vorherigen Anspruch, wobei das Subjekt ein Mensch ist und die Struktur (109) in der Form einer menschlichen Figur geformt ist, und optional wobei die menschenförmige Struktur mindestens einen beweglich angebrachten Kopf, Hals, Arm, Torso oder Bein und einen angetriebenen Aktuator zum Bewegen des Kopfs, Halses, Arms, Torsos oder Beins beinhaltet und optional wobei das System mindestens einen Bewegungssensor und eine Bewegungsverarbeitungsmaschine beinhaltet, um Bewegungen eines Subjekts in Bewegungsbefehle zu übersetzen, die an den mindestens einen Aktuator gesendet werden, wodurch ein Benutzer die Bewegung der Struktur (109) steuern kann.

11. Visuelles Modellierungssystem nach einem vorherigen Anspruch, wobei die Struktur (109) mindestens zehnmal größer ist als das gescannte Objekt und optional wobei der erste Scan-Datensatz ein Video ist und wobei das elektronische Beleuchtungssteuersystem die adressierbaren Beleuchtungselemente mit Energie versorgt, um ein bewegtes Bild auf der Struktur (109) zu erzeugen.

12. Visuelles Modellierungssystem nach einem vorherigen Anspruch, wobei die Leuchtelemente nach außen gerichtete Leuchtdioden sind, die in einer Vielzahl von vertikal beabstandeten horizontalen Reihen angeordnet sind.

13. Visuelles Modellierungssystem nach Anspruch 12, wenn abhängig von Anspruch 10, wobei der Kopf und der vordere Teil des Torsos eine höhere Dichte an Leuchtdioden aufweisen als der Rest eines Körpers der menschenförmigen Struktur und optional wobei ein Gesichtsabschnitt des Kopfs eine höhere Dichte an Leuchtdioden (410) aufweist als der vordere Abschnitt des Kopfs und Torsos.

14. Visuelles Modellierungssystem nach einem vorherigen Anspruch, wobei die Struktur (109) eine Vielzahl von miteinander verbundenen Blöcken umfasst, jeder Block umfassend mindestens ein adressierbares Beleuchtungselement (410) und optional wobei die Blöcke in Form von Pixelkacheln sind und optional wobei jeder Block Verbindungselemente umfasst, die konfiguriert sind, um jeden Block lösbar mit jedem benachbarten Block zu verbinden.

15. Verfahren zum Ausführen eines visuellen Modellierungssystems nach Anspruch 1, **dadurch gekennzeichnet, dass** das Verfahren die Schritte eines Erzeugens eines zweiten Scan-Datensatzes durch Aufbauen eines virtuellen 3D-Datenmodells einer Struktur, das die Stelle der adressierbaren Beleuchtungselemente (410) und eine Reihenfolge, in der sie adressiert werden, definiert, unter Verwendung des Struktur-Scanmoduls (400) umfasst, das Verfahren umfassend die folgenden Schritte:
a) Betreiben eines elektronischen Beleuchtungssteuersystems (420) unter Verwendung des Struktur-Scanmoduls (400), um eines einer Vielzahl von adressierbaren Beleuchtungselementen (410) auf der Strukturoberfläche gemäß einer Karte adressierbarer Beleuchtungselemente mit Energie zu versorgen, wobei die Karte in einem Speicher des elektronischen Beleuchtungssteuersystems (420) gespeichert ist, wobei das elektronische Beleuchtungssteuersystem (420) dem Struktur-Scanmodul (400) bestätigt, dass das adressierbare Beleuchtungselement (410) mit Energie versorgt ist;
b) sobald eine Bestätigung an dem Struktur-Scanmodul (400) empfangen wird, Betreiben mindestens einer Scan-Ausrüstung (430) zum Erzeugen eines 3D-Punktmodells der Struktur,
c) Verarbeiten, durch das Struktur-Scanmodul (400), des 3D-Punktmodells, um eine Position des energieversorgten adressierbaren Beleuchtungselements (410) auf der Strukturoberfläche zu identifizieren,
d) Übertragen eines Signals an das elektronische Beleuchtungssteuersystem (420), um das energieversorgte adressierbare Beleuchtungselement (410) auszuschalten;
e) sobald von dem elektronischen Beleuchtungssteuersystem (420) eine Bestätigung empfangen wird, dass das energieversorgte adressierbare Beleuchtungselement (410) ausgeschaltet ist, Hinzufügen, mittels des Struktur-Scanmoduls (400), der erfassten Stelle des adressierbaren Beleuchtungselements zu einem 3D-Modell und einem Zuordnungsmodell der Struktur, und
f) Wiederholen von Schritt a) bis e) für die verbleibenden adressierbaren Beleuchtungselemente (410), wobei Schritt b) die folgenden Schritte umfasst:
b1) Speichern des Scanmodells; und
b2) Übertragen der gespeicherten Modelle an das Struktur-Scanmodul (400) zum weiteren Verarbeiten,
wobei das Verfahren ferner die folgenden Schritte umfasst:
g) Empfang des erzeugten ersten Scan-Datensatzes
h) Zuordnen, um den ersten Scan-Datensatz mit positionsmäßig entsprechenden Beleuchtungselementen (410) in Beziehung zu setzen, und
i) Energieversorgen der adressierbaren Beleuchtungselemente (410) gemäß der Zuordnungsmaschine-Beziehung zwischen dem ersten und dem zweiten Scan-Datensatz.

## Revendications

1. Système de modélisation visuelle, comprenant :
un premier ensemble de données de balayage associé à un sujet ;
une structure (109) ayant une pluralité d'éléments d'éclairage adressables (410) ;
un deuxième ensemble de données de balayage associé à l'emplacement des éléments d'éclairage adressables (410) sur la surface de la structure (109) ;
un système de traitement d'image basé sur un processeur (206) comprenant un module de réception de données pour recevoir le premier ensemble de données de balayage généré, et un moteur de mappage pour associer le premier ensemble de données de balayage à des éléments d'éclairage (410) correspondant en position sur la structure (109) comme défini par le deuxième ensemble de données de balayage ; et
un système de commande d'éclairage électronique (420) comprenant une source d'alimentation et un contrôleur d'éclairage en communication avec la pluralité d'éléments d'éclairage adressables (410), dans lequel le système de commande d'éclairage électronique (420) alimente les éléments d'éclairage adressables (410) conformément à la relation de moteur de mappage entre les premier et deuxième ensembles de données de balayage ;
**caractérisé en ce que** le système de modélisation visuelle comprend un module de balayage de structure (400) utilisable pour générer le deuxième ensemble de données de balayage en construisant un modèle virtuel 3D de la structure (109) définissant l'emplacement des éléments d'éclairage adressables (410) et un ordre dans lequel ils sont adressés, le module de balayage de structure (400) étant configuré pour construire le modèle virtuel 3D de la structure en effectuant les étapes de :
a) actionnement du système de commande d'éclairage électronique (420) pour parcourir les éléments d'éclairage adressables (410) un par un ;
b) actionnement d'un équipement de balayage (430) du système de modélisation visuelle configuré pour balayer la structure (109) sous différents angles, l'équipement de balayage (430) étant configuré pour détecter la lumière émise par chaque élément d'éclairage adressable (410) alimenté ;
c) construction d'un nuage de points à partir de la lumière détectée émise par chaque élément d'éclairage adressable (410), chaque point définissant l'emplacement des éléments d'éclairage adressables (410) sur la surface de la structure (109) et l'ordre dans lequel ils sont adressés par le système de commande d'éclairage électronique (420) ; et
d) conversion du nuage de points en un modèle virtuel 3D de la structure (109).

2. Système de modélisation visuelle selon la revendication 1, dans lequel les étapes a) et b) sont exécutées de manière synchrone de sorte que lorsque chaque élément d'éclairage adressable (410) est excité, l'équipement de balayage (430) soit actionné en même temps, et éventuellement dans lequel les étapes a) et d) sont réalisées au moyen d'un programme informatique exécutable chargé dans une mémoire d'un processeur.

3. Système de modélisation visuelle selon l'une quelconque des revendications précédentes, dans lequel l'équipement de balayage (430) comprend au moins un scanner rotatif et éventuellement dans lequel l'équipement de balayage (430) comprend au moins un scanner LIDAR agencé pour identifier une position spatiale de l'élément d'éclairage adressable (410), et au moins un scanner RASTER agencé pour identifier l'élément d'éclairage adressable (410) comme un point lumineux.

4. Système de modélisation visuelle selon la revendication 3, dans lequel le système de commande d'éclairage électronique (420) est configuré pour comparer le modèle virtuel 3D généré à une carte d'éléments d'éclairage adressables attendue de la structure pour identifier la présence d'éléments d'éclairage adressables (410) défectueux sur la surface de la structure provoquant un écart d'uniformité de luminescence.

5. Système de modélisation visuelle selon la revendication 4, dans lequel le système de commande d'éclairage électronique (420) est configuré pour générer une liste contenant l'emplacement des éléments d'éclairage adressables défectueux détectés, laquelle liste est communiquée via un réseau de communication à un administrateur système.

6. Système de modélisation visuelle selon la revendication 4 ou 5, dans lequel le système de commande d'éclairage électronique (420) est configuré, lorsqu'une non-uniformité de luminance et/ou de couleur est détectée, pour ajuster l'actionnement d'éléments d'éclairage adressables voisins de la zone de structure affectée et éventuellement dans lequel le système de commande d'éclairage électronique (420) est configuré pour ajuster l'un quelconque du courant fourni à chaque élément d'éclairage adressable, la largeur d'impulsion fournie à chaque élément d'éclairage adressable.

7. Système de modélisation visuelle selon l'une quelconque des revendications précédentes, dans lequel la structure (109) est formée dans la forme approximative du type de sujet balayé et éventuellement dans lequel le premier ensemble de données de balayage est un ensemble tridimensionnel de données, et la structure (109) est formée dans la forme tridimensionnelle approximative du type de sujet balayé.

8. Système de modélisation visuelle selon l'une quelconque des revendications précédentes, dans lequel le moteur de mappage est configuré pour mapper les emplacements de points 3D définis dans le deuxième ensemble de données de balayage à des points d'image 2D définis dans le premier ensemble de données et éventuellement dans lequel le mappage est effectué au moyen d'une technique de cartographie UV.

9. Système de modélisation visuelle selon l'une quelconque des revendications précédentes, comprenant en outre un scanner tridimensionnel (202) pour balayer un sujet à modéliser visuellement.

10. Système de modélisation visuelle selon l'une quelconque des revendications précédentes, dans lequel le sujet est un humain et la structure (109) est formée sous la forme d'un visage humain et éventuellement dans lequel la structure de forme humaine comprend au moins l'un parmi une tête, un cou, un bras, un torse ou une jambe attaché de manière mobile et un actionneur motorisé pour déplacer l'au moins l'un parmi la tête, le cou, le bras, le torse ou la jambe et éventuellement dans lequel le système comprend au moins un capteur de mouvement et un moteur de traitement de mouvement pour traduire les mouvements d'un sujet en commandes de mouvement envoyées à l'au moins un actionneur grâce auquel un utilisateur peut commander le mouvement de la structure (109).

11. Système de modélisation visuelle selon l'une quelconque des revendications précédentes, dans lequel la structure (109) est au moins dix fois plus grande que le sujet balayé et éventuellement dans lequel le premier ensemble de données de balayage est une vidéo et dans lequel le système de commande d'éclairage électronique alimente les éléments d'éclairage adressables pour générer une image animée sur la structure (109).

12. Système de modélisation visuelle selon l'une quelconque des revendications précédentes, dans lequel les éléments d'éclairage sont des diodes électroluminescentes tournées vers l'extérieur agencées en une pluralité de rangées horizontales espacées verticalement.

13. Système de modélisation visuelle selon la revendication 12, lorsqu'elle dépend de la revendication 10, dans lequel la tête et la partie avant du torse ont une densité de diodes électroluminescentes plus élevée que le reste d'un corps de la structure de forme humaine et éventuellement dans lequel une partie de visage de la tête a une densité de diodes électroluminescentes (410) plus élevée que la partie avant de la tête et du torse.

14. Système de modélisation visuelle selon l'une quelconque des revendications précédentes, dans lequel la structure (109) comprend une pluralité de blocs d'interconnexion, chaque bloc comprenant au moins un élément d'éclairage adressable (410) et éventuellement dans lequel les blocs sont sous la forme de mosaïques de pixels et éventuellement dans lequel chaque bloc comprend des éléments d'interconnexion configurés pour connecter de manière libérable chaque bloc à chaque bloc voisin.

15. Procédé d'exécution d'un système de modélisation visuelle selon la revendication 1, **caractérisé en ce que** le procédé comprend les étapes de génération d'un deuxième ensemble de données de balayage en construisant un modèle de données virtuelles 3D d'une structure définissant l'emplacement des éléments d'éclairage adressables (410) et un ordre dans lequel ils sont adressés, à l'aide du module de balayage de structure (400), le procédé comprenant les étapes de :
a) actionnement à l'aide du module de balayage de structure (400) d'un système de commande d'éclairage électronique (420) pour alimenter l'un d'une pluralité d'éléments d'éclairage adressables (410) sur la surface de la structure selon une carte d'éléments d'éclairage adressables, laquelle carte est stockée dans une mémoire du système de commande d'éclairage électronique (420), dans lequel le système de commande d'éclairage électronique (420) confirme au module de balayage de structure (400) que l'élément d'éclairage adressable (410) est alimenté ;
b) une fois la confirmation reçue au niveau du module de balayage de structure (400), actionnement d'au moins un équipement de balayage (430) pour générer un modèle de points 3D de la structure,
c) traitement par le module de balayage de structure (400) du modèle de points 3D pour identifier une position de l'élément d'éclairage adressable (410) alimenté sur la surface de la structure ;
d) transmission d'un signal au système de commande d'éclairage électronique (420) pour éteindre l'élément d'éclairage adressable (410) alimenté ;
e) une fois la confirmation reçue du système de commande d'éclairage électronique (420) que l'élément d'éclairage adressable (410) alimenté est éteint, ajout au moyen du module de balayage de structure (400) de la position détectée de l'élément d'éclairage adressable à un modèle 3D et mappage du modèle de la structure ; et
f) répétition des étapes a) à e) pour les éléments d'éclairage adressables (410) restants, dans lequel l'étape b) comprend les étapes de :
b1) stockage du modèle de balayage ; et
b2) transmission des modèles stockés au module de balayage de structure (400) pour un traitement ultérieur ;
dans lequel le procédé comprend en outre les étapes de :
g) réception du premier ensemble de données de balayage généré
h) mappage pour relier le premier ensemble de données de balayage à des éléments d'éclairage (410) correspondant en position, et
i) alimentation des éléments d'éclairage adressables (410) conformément à la relation du moteur de mappage entre les premier et deuxième ensembles de données de balayage.
